# EUROPEAN PATENT APPLICATION

(11) **EP 0 859 444 A2**
(43) Date of publication of application: **19.08.1998**
(21) Application number: 98102310.4
(22) Date of filing: 11.02.1998
(51) Int. Cl.: H02H 9/04

(54) **Circuit for electrostatic discharge (ESD) protection**

(30) Priority: 18.02.1997 US 801874
(71) Applicant: MOTOROLA, INC., Schaumburg, IL 60196 (US)
(72) Inventor: Smith, Jeremy C., Austin, Texas 78739 (US)
(74) Representative: Gibson, Sarah Jane

(57) **Abstract**

An electrostatic discharge (ESD) circuit (12) provides robust protection to an input/output driver circuit (10). The discharge path is provided by a parasitic bipolar transistor (202). The parasitic bipolar device is triggered by a combination of a MOSFET (204) and a string of diodes (200). The trigger point of the MOSFET is programmable by varying the number of individual diodes in the string of diodes.

## Description

### Field of the Invention

The present invention generally relates to electronic integrated circuits, and more specifically to an electrostatic discharge protection circuit for an integrated circuit.

### Background of the Invention

In the semiconductor industry, the use of electrostatic discharge protection (ESD) circuits is known. ESD circuits ensure that integrated semiconductor devices are not destroyed by static electricity during routine post-manufacture processes. However, current and foreseeable trends in the semiconductor industry are adversely impacting the effectiveness of known ESD circuits.

For instance, the use of heavily doped epitaxial (epi) substrates prevents metal oxide semiconductor (MOS) field effect transistors (FETs) and thick field oxide (TFO) devices from acting as current shunting devices. In normal use, a heavily doped substrate is desirable. Such a substrate reduces the undesirable occurrence of "latch-up." During latch-up, two parasitic bipolar transistors formed by two complimentary MOSFETs create a feedback loop. In the feedback loop, the base of the first parasitic bipolar device is also the collector of the second device. Conversely, the base of the second device is the collector of the first device. When both of these transistors are conducting, large amounts of current can flow between two power supplies. A high current event applied to one of the terminals of the two transistors can cause the two parasitic transistors to conduct. A heavily doped epitaxial substrate acts to break the feedback loop by grounding the substrate and, hence, the base of one device and the collector of the other.

The use of salicide bonding layers to reduce sheet resistivity (rho) also decreases the effectiveness of known ESD circuits. Here, several MOSFETs or several fingers forming a single MOSFET act as a parasitic bipolar device to provide ESD protection. Such an ESD device relies upon the "snap-back" current-voltage characteristics of a parasitic bipolar transistor. There, a current begins to flow through a bipolar transistor at a certain collector-to-emitter voltage, Vtl. Thereafter, the collector-to-emitter voltage decreases as the current increases, "snapping-back" from Vtl. Later, the trend reverses, causing the collector-to-emitter voltage to rise as the current also rises. Eventually, the bipolar transistor fails at another particular collector-to-emitter voltage, Vt2. The low resistance of the salicide layer can cause the ultimate breakdown voltage, Vt2, to be lower than the initial voltage, Vtl. Such a relationship causes the first MOSFET or first finger of the MOSFET to breakdown at a voltage less than the voltage at which the second MOSFET turns on. Consequently, the protection provided by the group of MOSFETs is no greater than the protection provided by a single MOSFET.

Some known ESD circuits rely on the inherent capacitance between the voltage rails of a integrated circuit to shunt excess energy applied to one voltage rail to the other. This strategy minimizes the total number of devices necessary to provide protection. However, this strategy also fails as the capacitance of the integrated circuit drops. Consequently, one ESD circuit designed for a particular integrated circuit may not be sufficient for another circuit. Furthermore, die reduction is one of the overriding trends in the semiconductor industry. An ESD circuit designed for a particular integrated circuit may not be sufficient for the same circuit once the geometry of the circuit is reduced or "shrunk."
Other known ESD circuits rely on diode strings to shunt power. Unfortunately, diodes leak current. Furthermore, each diode's leakage increases with its temperature. Another trend in the semiconductor industry is to design and manufacture integrated circuits that consume as little current as possible and that are suitable for wide usage. Both of these goals is adversely impacted by leaky designs that are limited by environmental concerns.

### Brief Description of the Drawings

FIG. 1 depicts a partial block diagram, partial schematic diagram of an input/output driver circuit constructed according to the present invention;
FIG. 2 depicts a circuit diagram of an ESD circuit illustrated in FIG. 1;
FIG. 3 depicts a circuit diagram of a high voltage blocker illustrated in FIG. 1;
PIG. 4 depicts a circuit diagram of a gate pump illustrated in FIG. 1; and
FIG. 5 depicts a circuit diagram of a well pump illustrated in FIG. 1.

### Detailed Description of the Invention

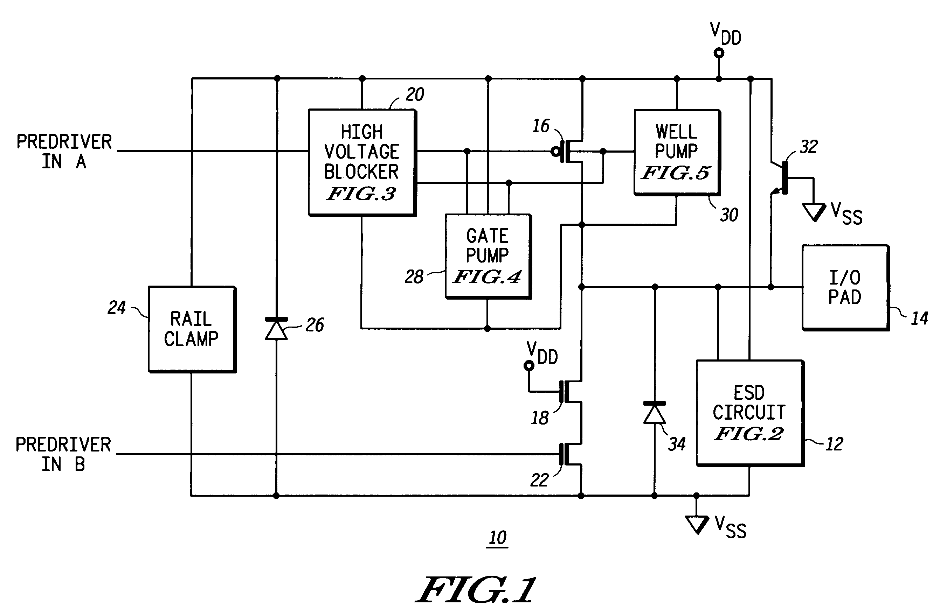

FIG. 1 depicts a partial block diagram, partial schematic diagram of an input/output (I/O) driver circuit 10 constructed according to the present invention. I/O driver circuit 10 includes an ESD circuit 12 to provide protection against electrostatic discharge events and against electrical overstress (EOS) events. ESD circuit 12 is more fully described below in connection with PIG. 2.

At this point, it is appropriate to note that ESD circuit 12 uses a MOSFET transistor to trigger a parasitic bipolar transistor that shunts excess energy. The use of a trigger current lowers the point at which the parasitic bipolar transistor begins to shunt energy. The use of a parasitic bipolar transistor eliminates the need for a true bipolar device. A true bipolar transistor is one who's control electrode is separate from the semiconductor substrate and, hence, is directly controllable. Typically, the inclusion of a bipolar device significantly increases the manufacturing costs of the integrated circuit. The direct application of the trigger current to the control electrode of the parasitic bipolar transistor locally overcomes the voltage potential caused by a heavily doped substrate. Normally, the substrate is coupled to the lesser of two voltage supplies. The trigger point is easily programmable by increasing or decreasing the number of diodes in a diode string. However, it is the parasitic bipolar device that shunts the majority of the excess energy, not the diode string. Consequently, the individual diodes may be made very small to minimize current leakage and temperature induced performance variations. Also, ESD circuit 12 does not rely on the capacitance between the two voltage rails. Therefore, ESD circuit 12 may be incorporated into small integrated circuits, into large integrated circuits, and into standard cell libraries used throughout a design organization. One skilled in the art will readily appreciate the suitability of ESD circuit 12 to current and future integrated circuit process flows.

Continuing with FIG. 1, an input/output (I/O) pad 14 generates a voltage level that is transmitted to another device external to the integrated circuit incorporating I/O driver circuit 10. In the current embodiment, I/O driver circuit 10 outputs 0 or 3.3 Volts on I/O pad 14. In other embodiments, I/O driver circuit 10 may include circuitry to receive voltage levels from other devices external to the integrated circuit incorporating I/O driver circuit 10. In such embodiments, the voltages may also be 0 or 3.3 Volts. In still other embodiments, the maximum received voltage level may exceed the maximum output voltage level. For instance, I/O driver circuit 10 may output either 0 or 3.3 Volt signals but may receive 0 or 5 Volt signals.

I/O pad 14 is connected to a first current electrode of a p-type MOSFET transistor 16 and to a first current electrode of an retype MOSFET transistor 18. A second current electrode and a control electrode of transistor 16 is coupled to a first voltage supply, VDD, and to an output terminal of a high voltage blocker 20, respectively. High voltage blocker 20 receives four inputs, PREDRIVER IN A, VDD, I/O pad 14, and the well of transistor 16. High voltage blocker 20 is described below in connection with FIG. 3.

A second current electrode and a control electrode of transistor 18 is coupled to a first current electrode of an retype MOSFET transistor 22 and to a first voltage supply, VDD, respectively. A second current electrode and a control electrode of transistor 22 is coupled to a second voltage supply, Vss, and to an input PREDRIVER IN B. respectively.

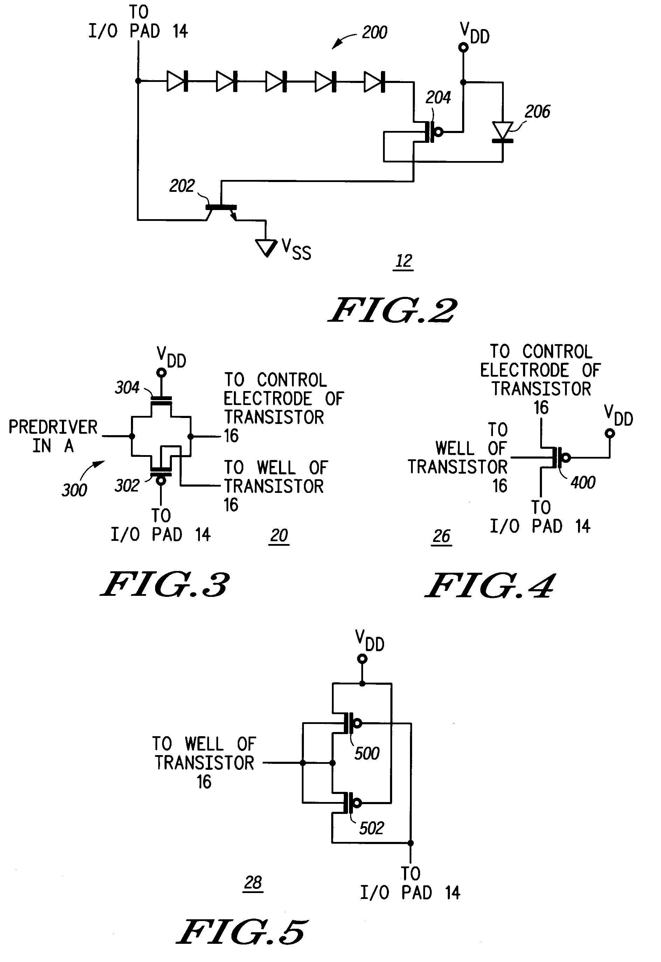

I/O driver circuit 10 also includes a rail clamp 24 and a diode 26 coupled in parallel between VDD and Vss. Rail clamp 24 may be the inherent capacitance of the integrated circuit incorporating I/O driver circuit 10, if sufficient, or may be an active circuit that provides a discharge path between VDD and Vss during an ESD event. Diode 26 is coupled such that it conducts current when vSs is approximately 0.5 Volts higher than VDD. Normally, VDD is 3.3 Volts higher than VSs. Four terminals of a gate pump 28 are coupled to VDD, to the control electrode of a transistor 16, to I/O pad 14, and to the well of transistor 16, respectively. Gate pump 28 is described below in connection with FIG. 4. Three terminals of a well pump 30 are coupled to VDDJ to the well of a transistor 16, and to I/O pad 14, respectively. Well pump 30 is described below in connection with FIG. 5. A first current electrode, a second current electrode, and a control electrode of an npn bipolar transistor 32 is coupled to VDD, to I/O pad 14, and to VSs, respectively. A first terminal and a second terminal of a diode 34 is coupled to a I/O pad 14 and to VSs, respectively. Diode 34 is coupled such that it conducts current when Vss is approximately 0.5 Volts higher than the voltage present on I/O pad 14. Normally, the voltage level present on I/O pad 14 is greater than or equal higher to Vss.

The operation of I/O driver circuit 10 may be conveniently described with reference to two modes of operation: (1) normal I/O operation, and (2) electrostatic discharge protection. The electrostatic discharge protection function may be further divided into four cases paralleling the four methods used to test the human body model: (1) positive input voltage with respect to VDD, (2) positive input voltage with respect to vSss (3) negative input voltage with respect to VDD, and (4) negative input voltage with respect to Vss

### NORMAL OPERATION

In normal operation, I/O driver circuit 10 is either used as an output only or an input only driver. The particular function is selected by the logic state of control signals PREDRIVER IN A and PREDRIVER IN B. If I/O driver circuit 10 is to be used as an output only buffer, then the signal to be output (generated elsewhere) is applied to both the control electrode of transistor 16 and to the control electrode of transistor 22. The signal to be output is applied to the control electrode of transistor 16 via high voltage blocker 20. Thus, PREDRIVER IN A and PREDRIVER IN B are both at the potential of the desired output signal. Depending upon which transistor is enabled, either voltage supply VDD or voltage supply VSS will be coupled to I/O pad 14. If I/O driver circuit 10 is used as an input only buffer, then PREDRIVER IN A is set to VDD and PREDRIVER IN B is set to VSs. These voltage levels place I/O pad 14 into a high impedance state. In this case, a voltage generated external to I/O driver circuit 10 is applied to I/O pad 14 and buffered by circuitry (not shown).

As described above, I/O driver circuit 10 is 5 volt tolerant. If a 5 Volt signal is applied to I/O pad 14, then no damage will occur. The control electrode and the well of transistor 16 are both biased with the higher input voltage level by gate pump 28 and by well pump 30, respectively. This bias ensures that transistor 16 does not conduct current when a voltage greater than voltage supply VDD is applied to I/O pad 14. Furthermore, high voltage blocker 20 ensures that the bias voltage applied to the control electrode of transistor 16 is not applied to internal circuitry (not shown).

### ESD EVENTS

### Positive Voltage Input With Respect to VDD

In this case, a large positive voltage level is applied to I/O pad 14 with respect to voltage supply VDD. The large positive input voltage causes ESD circuit 12 to shunt energy from I/O pad 14 to Vss, which is floating in this scenario. The voltage on voltage supply Vss begins to rise, forward biasing diode 26. ESD circuit 12, voltage supply Vss, and diode 26 thereby form a discharge path from I/O pad 14 to voltage supply VDD.

### Positive Voltage Input With Respect to V5S

In this case, a large positive voltage level is applied to I/O pad 14 with respect to voltage supply Vss. Again, the large positive input voltage causes ESD circuit 12 to shunt energy from I/O pad 14 to Vss. ESD circuit 12 thereby forms a discharge path from I/O pad 14 to voltage supply vSs

### Negative Input Voltage With Respect to VDD

Here, a large negative voltage level is applied to I/O pad 14 with respect to voltage level VDD. This large negative voltage forward biases diode 34 and allows rail clamp 24 to couple the voltage supply Vss to the voltage supply VDD. Diode 34 and rail clamp 24 form a discharge path from the voltage supply VDD to I/O pad 14. Again, rail clamp 24 may be the inherent capacitance of the integrated circuit incorporating I/O driver circuit 10 or may be an active clamp circuit. There is also a secondary shunt path from the voltage supply VDD to I/O pad 14 via transistor 32. In this secondary case, the inherent capacitance (or rail clamp 24) couples VDD to Vss and ultimately to the control electrode of transistor 32. Transistor 32 is then forward biased causing current to flow from the voltage supply ODDS through transistor 32, to I/O pad 14.

### Negative Voltage Input With Respect to V5S

In this case, a large negative voltage is applied to I/O pad 14 with respect to voltage supply Vss. Here, diode 34 becomes forward biased, shunting energy from the voltage supply Vss to I/O pad 14. There is also a secondary shunt path from the voltage supply Vss to I/O pad 14 via transistor 32. In this secondary case, the control electrode-to-second current electrode junction of transistor 32 is forwarded biased, creating a direct current path from voltage supply Vss to I/O pad 14. As depicted in FIG. 1, the voltage supply Vss is coupled to the control electrode of transistor 32.

FIG. 2 depicts a circuit diagram of ESD circuit 12 illustrated in FIG. 1. Each of a first terminal of a string of serially connected diodes 200 and a first current electrode of a parasitic npn bipolar transistor 202 is coupled to I/O pad 14. A second terminal of string of diodes 200 is coupled to a first current electrode of a p-type MOSFET transistor 204. In the depicted embodiment, string of diodes 200 contains five diodes. A second current electrode and a control electrode of transistor 202 is coupled to the voltage supply Vss and to a second current electrode of transistor 204, respectively. A control electrode of transistor 204 is coupled to a first terminal of a diode 206 and to the voltage supply VDD. A second terminal of diode 206 is coupled to the well of transistor 204.

The individual diodes in string of diodes 200 are connected such that they conduct current when the voltage level present on I/O pad 14 exceeds the sum of, approximately, (5*0.5) Volts plus a drain. TFO devices consist of two diffusion regions of similar conductivity type, in proximity to each other, and disposed in a semiconductor body of opposite conductivity type. Typically, two ntype regions are disposed in a p-type substrate. A thick oxide layer forms on top of the substrate in the areas between like or opposite diffused or implanted regions.

Silicon-on-insulator (SOI) is an emerging technology in which semiconductors are manufactured on insulating substrates such as silicon dioxide, sapphire, diamond, etc. The present invention may be embodied into such a technology with similar benefits. In such a technology, a contact to supply trigger current may be formed laterally to the body of transistor 202.

The operation of ESD circuit 12 may be conveniently described with reference to two possible events: (1) electrostatic discharge (ESD) events, and (2) electrical overstress (EOS) events. Generally, ESD events are shorter than EOS events and typically occur when the integrated circuit is not powered.

### ESD EVENTS

As described above in connection with FIG. 1, ESD circuit 12 provides ESD protection in two cases: (1) positive input voltage with respect to ODDS and (2) positive input voltage with respect to Vss. In the first case, transistor 204 begins supplying a trigger current to transistor 202 when the voltage of I/O pad 14 exceeds the sum of, approximately, (5*0.5) Volts plus a threshold voltage level of transistor 204. A short time thereafter, transistor 202 shunts current from I/O pad 14 to the voltage supply Vss. Diode 26 (FIG. 1) completes the circuit path to the voltage supply VDD. In the second case, transistor 204 also begins supplying a trigger current to transistor 202 when the voltage of I/O pad 14 exceeds the sum of, approximately, (5*0.5) Volts plus a threshold voltage level of transistor 204. A short time thereafter, transistor 202 directly shunts current from I/O pad 14 to the voltage supply Vss.

### EOS EVENTS

The operation of ESD circuit 12 during an EOS event is similar to its operation in an ESD event. Here, transistor 204 begins supplying a trigger current to transistor 202 when the voltage of I/O pad 14 exceeds the sum of, approximately, (5*0.5) Volts plus a threshold voltage level of transistor 204 plus the control electrode voltage of transistor 204 (VDD)

The number of individual diodes in string of diodes 200 is determined by the difference between the minimum allowable voltage supply level of VDD and the maximum allowable specified input voltage on I/O pad 14 divided by the voltage drop across each diode. Typically these values are 10% less and 10% greater than the nominal values of VDD and of the input voltage, respectively. In the described embodiment, VDD is 3.3 Volts and the maximum tolerable input voltage is 5.0 Volts. Therefore, five diodes (5.5-3.0)/(0.5) were selected.

In a second embodiment of ESD circuit 12, diode 206 is omitted. In this case, transistor 204 has characteristics of a parasitic vertical and a parasitic lateral pnp-type bipolar transistor. These characteristics generate a base current that raises the local substrate potential of transistor 202 if transistor 204 is in close physical proximity to transistor 202. This additional base current further triggers transistor 202. In still other embodiments, diode 206 may be replaced with a resistor or a direct electrical connection.

In the preferred embodiment, transistor 202 is fabricated by placing two retype wells into a p-type substrate. The two retype wells form the first and second current electrodes. A p-type contact is located between the two retype wells. The p-type contact to the ptype substrate forms the control electrode. This basic design may be tiled to increase the total width of transistor 202 without unnecessarily consuming space on the integrated circuit. Also, it is customary to periodically tie the p-type substrate to the voltage supply VSS. These ties should not be placed adjacent to transistor 202. Otherwise, the substrate lifting effect provided by the trigger current will be abated.

FIG. 3 depicts a circuit diagram of high voltage blocker 20 illustrated in FIG. 1. High voltage blocker 20 comprises a transmission gate 300 itself consisting of a p-type MOSFET transistor 302 and an n-type MOSFET transistor 304. A control electrode of transistor 302 is coupled to I/O pad 14. A control electrode of transistor 304 is coupled to the voltage supply VDD. A first current electrode of transistors 302 and 304 receive the signal PREDRIVER IN A. A second current electrode of transistors 302 and 304 are coupled to the control electrode of transistor 16. The body of transistor 302 is also connected to the well of transistor 16.

In operation, the n-type device in transmission gate 300 limits the voltage passed from I/O pad 14 to internal circuitry (not shown) to (3.3-Vtn) Volts, where Vtn is the threshold voltage of transistor 304. Transistor 302 passes a control signal equal to VDD (without attenuation) to the control electrode of transistor 16.

FIG. 4 depicts a circuit diagram of gate pump 28 illustrated in FIG. 1. Gate pump 28 comprises a p-type MOSFET transistor 400. A first current electrode, a second current electrode, and a control electrode of transistor 400 is coupled to the control electrode of transistor 16, to I/O pad 14, and to the supply voltage VDD, respectively. The body of transistor 400 is also connected to the well of transistor 16.

FIG. 5 depicts a circuit diagram of well pump 30 illustrated in FIG. 1. Well pump 30 comprises two p-type MOSFETs 500 and 502. A first current electrode, a second current electrode, and a control electrode of transistor 500 is coupled to the voltage supply VDD, to the well of transistor 16, and to I/O pad 14, respectively. A first current electrode, a second current electrode, and a control electrode of transistor 502 is coupled to the well of transistor 16, to I/O pad 14, and to the voltage supply ODDS respectively. The bodies of transistors 500 and 502 are also connected to the well of transistor 16.

In operation, transistors 500 and 502 adjust the well of transistor 16 when the voltage level present on I/O pad 14 exceeds the voltage supply VDD. Specifically, when the voltage level present on I/O pad 14 initially exceeds the voltage supply VDD, then transistor 502 allows the well of transistor 16 to track the increased voltage level. This strategy prevents the drain diode of transistor 16 from forward biasing. Conversely, when the voltage level present on I/O pad 14 returns to VDD or vSsX then transistor 500 restores the well to its initial value, VDD by releasing charge to the voltage supply VDD.

Although the present invention has been described with reference to a specific embodiment, further modifications and improvements will occur to those skilled in the art. For instance, the disclosed invention is described with respect to a particular set of transistor conductivity types. One skilled, in the art, with the above description may change conductivity types under certain circumstances to tailor the invention to a particular process or embodiment. One skilled in the art may substitute other structures to accomplish the same purpose. It is to be understood therefore, that the invention encompasses all such modifications that do not depart from the spirit and scope of the invention as defined in the appended claims.

## Claims

1. A circuit for electrostatic discharge protection, comprising:
an input terminal (14);
a diode string (200) further comprising:
at least one diode comprising a first terminal and a second terminal, wherein the first terminal is coupled to the input terminal;
a transistor comprising a first current electrode, a second current electrode, and a control electrode, wherein the first current electrode thereof is coupled to the second terminal of the diode string, and the control electrode thereof receives a first voltage supply; and
a parasitic bipolar device (202), wherein:
the parasitic bipolar device comprising a first diffusion region and a second diffusion region of a similar conductivity type disposed in a body of an opposite conductivity type,
the first diffusion region is coupled to the input terminal,
the second diffusion region receives a second voltage supply,
the body is coupled to the second current electrode of the transistor.

2. The circuit in claim 1 wherein:
the body receives the second voltage supply.

3. The circuit in claim 1 wherein:
the transistor is a metal oxide semiconductor field effect transistor.

4. The circuit in claim 1 wherein:
the diode string comprises a plurality of serially coupled diodes.

5. The circuit in claim 1 further comprising:
a current blocking diode (206) having a first terminal and a second terminal, wherein:
the first terminal thereof receives the first voltage supply, and the second terminal thereof is coupled to a body of the transistor.

6. The circuit in claim 1 further comprising:
a current limiting resistor having a first terminal and a second terminal, wherein:
the first terminal thereof receives the first voltage supply, and the second terminal thereof is coupled to a body of the transistor.

7. The circuit in claim 1 wherein a body of the transistor receives the first voltage supply.

8. The circuit in claim 1 further comprising
an electrical contact to the body of the parasitic bipolar device disposed between the first diffusion region and the second diffusion region.

9. The circuit in claim 1 further comprising
an electrical contact to the body of the parasitic bipolar device, wherein the first diffusion region is disposed between the second diffusion region and the electrical contact.

10. The circuit in claim 1 further comprising:
an electrical contact to the body of the parasitic bipolar device surrounding the first diffusion region and the second diffusion region.
